# EUROPÄISCHE PATENTSCHRIFT

(11) **EP 2 401 680 B1**
(45) Veröffentlichungstag und Bekanntmachung des Hinweises auf die Patenterteilung: **06.11.2013**
(21) Anmeldenummer: 09776141.5
(22) Anmeldetag: 26.02.2009
(51) Int. Cl.: G06F 12/02

(54) **VERFAHREN ZUR VERWALTUNG VON FLASHSPEICHERN MIT GEMISCHTEN SPEICHERTYPEN**
METHOD FOR MANAGING FLASH MEMORIES HAVING MIXED MEMORY TYPES
PROCÉDÉ DE GESTION DE MÉMOIRES FLASH PRÉSENTANT DES TYPES DE MÉMOIRES MIXTES

(43) Veröffentlichungstag der Anmeldung: 04.01.2012
(73) Patentinhaber: Hyperstone GmbH, 78467 Konstanz (DE)
(72) Erfinder: SCHMIDBERGER, Franz, 78464 Konstanz (DE)
(74) Vertreter: Reimann, Silke
(86) Internationale Anmeldenummer: PCT/DE2009/075011
(87) Internationale Veröffentlichungsnummer: WO 2010/097065

(56) Entgegenhaltungen:
- WO-A-2007/029259
- US-A1- 2008 140 918
- US-A1- 2008 209 112

## Beschreibung

Die Erfindung betrifft ein Verfahren zur Verwaltung eines Speichers mit mehreren Flashchips, die in eine Vielzahl von separat löschbaren physikalischen Blöcken gegliedert sind und diese Blöcke eine begrenzte maximale Löschhäufigkeit besitzen, und die Blöcke des Speichers über logische Blockadressen adressiert werden, die über eine Adresstabelle in physikalische Blockadressen umgesetzt werden, und in jedem Block ein Löschzähler mitgeführt wird.

Speichersysteme, die aus Flashchips aufgebaut sind, insbesondere sogenannte Solid State Disks, gewinnen immer mehr an Bedeutung und es besteht die Notwendigkeit, solche preiswert anbieten zu können.

Bei den Flashchips werden zwei unterschiedliche Typen verwendet. Die Single-Level-Cell-Chips SLC bieten eine hohe Anzahl von möglichen Schreib/Löschzyklen, sind aber relativ teuer. Die Multi-Level-Cell-Chips MLC sind wesentlich preiswerter, bieten aber nur eine deutlich geringere Anzahl von möglichen Schreib/Löschzyklen.

Die Flashchips sind in eine Vielzahl von realen Blöcken organisiert, die separat gelöscht werden können. Die Blöcke werden vom Computersystem über logische Blockadressen adressiert.

Beim Einsatz eines Speichers in einem Computersystem werden einige Daten häufig geändert, während andere Daten, wie etwa Applikationsprogramme, nur sehr selten überschrieben werden. Es ist nun wünschenswert, die selten geänderten Daten in den preiswerten Flashchips zu speichern und die teuren Flashchips nur für die häufig geänderten Daten vorzuhalten.

In Flashspeichern werden Wear-Leveling-Verfahren eingesetzt, um eine gleichmäßige Verteilung der notwendigen Schreib/Löschzyklen auf alle Blöcke zu erreichen und somit die Lebensdauer des Speichers zu maximieren.

Dazu wird über eine Adresstabelle eine Umsetzung von logischen Blockadressen in physikalische Blockadressen vorgenommen und diese Zuordnung entsprechend der Löschhäufigkeit der Blöcke verändert.

In der Patentanmeldung US2008/0209112A1 ist ein Speichersystem mit SLC- und MLC-Speicherchips beschrieben, bei dem vorrangig die SLC-Speicherchips genutzt werden. Wenn alle SLC-Speicherchips beschrieben sind, wird ein wenig genutzter SLC-Speicherblock in den MLC-Bereich kopiert, gelöscht und für neue Daten genutzt. Ein weitergehendes Wear-Leveling-Verfahren wird nicht genutzt.

Es ist die Aufgabe der Erfindung, ein Verfahren zu offenbaren, das es erlaubt, in einem Speicher zwei Typen von Flashchips mit unterschiedlich maximal möglichen Schreib/Löschzyklen zu kombinieren und dabei eine maximale Lebensdauer des Speichers zu erreichen.

Diese Aufgabe wird durch die Merkmale des Anspruchs 1 gelöst. Vorteilhafte Ausgestaltungen des Verfahrens sind in den Unteransprüchen beschrieben.

Das Speichersystem enthält einen Speichercontroller mit einer Firmware, in der das Verfahren durchgeführt wird. Alle Flashchips des Speichers sind an den Controller angeschlossen und werden von diesem verwaltet. Der Speicher ist erfindungsgemäß in zwei Bereiche geteilt, wovon der erste Bereich mit den Single-Level-Cell-Chips SLC ausgestattet ist, während der zweite Bereich die Multi-Level-Cell-Chips MLC enthält. Typischerweise beträgt die Größe des zweiten Bereiches ein Vielfaches des ersten Bereiches, es sind aber alle Größenverhältnisse möglich. Die Größen der separat löschbaren realen Blöcke können in den beiden Flashtypen unterschiedlich sein. Um das Verfahren in beiden Bereichen auf die gleiche Weise durchführen zu können, werden von der Firmware physikalische Blöcke gebildet, die eine feste Größe besitzen und in den beiden Bereichen aus unterschiedlich vielen realen Blöcken bestehen können.

In der Adressumsetzungstabelle ist zu jeder logischen Blockadresse eine physikalische Blockadresse eines Speicherblockes zugeordnet. Das übergeordnete Computersystem benutzt die logischen Blockadressen vollständig wahlfrei.

Das Verfahren sieht in einer Startphase vor, dass, wenn über die logische Blockadresse eine physikalische Adresse im zweiten Bereich angesprochen wird, dieser logischen Blockadresse nun in der Adresstabelle eine physikalische Blockadresse eines freien Speicherblocks aus dem ersten Bereich zugeordnet wird. Damit füllt sich der erste Bereich in der Startphase.

Jedem Block ist ein Löschzähler zugeordnet, der bei jedem Schreib/Löschzyklus erhöht wird. Wenn nun im ersten Bereich kein freier Block mehr vorhanden ist und ein weiterer Schreibvorgang auszuführen ist, wird ein Block mit dem niedrigsten Wert des Löschzählers im ersten Bereich gesucht und dieser in den zweiten Bereich kopiert. Die physikalischen Blockadressen zu den zugeordneten logischen Blockadressen dieser Blöcke in der Adresstabelle werden getauscht. Der Block im ersten Bereich wird gelöscht und mit den neuen Daten beschrieben.

Wenn alle Blöcke des ersten oder zweiten Bereiches gefüllt sind, wird in den NormalBetrieb der Speicherverwaltung übergegangen. Mit einem Wear-Leveling-Verfahren werden die Bereiche des Speichers entsprechend ihrer zulässigen Löschhäufigkeit gleichmäßig beansprucht und die Lebensdauer aller Flashchips des gesamten Speichers wird maximal ausgenutzt.

Für das Wear-Leveling-Verfahren werden in beiden Bereichen gelöschte Pufferblöcke vorgehalten, in die neue Daten für bereits beschriebene Blöcke eingeschrieben werden. Nach dem vollständigen Beschreiben des Pufferblockes wird seine physikalische Adresse anstelle des bisher adressierten physikalischen Blockes zu der benutzten logischen Blockadresse in die Adresstabelle eingetragen und der letztere gelöscht. Dabei wird dann sein Löschzähler erhöht.

Für die Bereiche wird jeweils eine Wear-Level-Schwelle definiert, die im ersten Bereich höher liegt und im zweiten Bereich niedriger liegt. Weiterhin wird für jeden Block ein Wear-Level-Class-Zähler mitgeführt. Der Löschzähler wird bei seiner Erhöhung daraufhin überprüft, ob sein Wert die für diesen Block gültige Wear-Level-Schwelle erreicht hat. Ist dies der Fall, wird der Wear-Level-Class-Zähler erhöht und der Löschzähler auf den Wert 0 zurückgestellt. Bei der Suche nach einem neuen Pufferblock für das erneute Beschreiben eines Blockes wird in dem gleichen Bereich des Speichers ein solcher Block gewählt, der einen niedrigen Wert seines Wear-Level-Class-Zählers aufweist. Auf diese Weise wird eine gleichmäßige Löschhäufigkeit der Blöcke innerhalb eines Bereiches erreicht.

Falls ein Block innerhalb des ersten Bereiches einen niedrigen Wert seines Wear-Level-Class-Zählers aufweist oder ein Block innerhalb des zweiten Bereiches einen hohen Wert seines Wear-Level-Class-Zählers aufweist, kann sein Inhalt in den jeweils anderen Bereich verschoben werden. Dazu werden eine Abwärtsschwelle, die den höchsten aktuellen Wert der Wear-Level-Class-Zähler im zweiten Bereich angibt, und eine Aufwärtsschwelle, die den niedrigsten aktuellen Wert der Wear-Level-Class-Zähler im ersten Bereich angibt, bestimmt. Wenn nun bei einer Erhöhung des Wear-Level-Class-Zählers im ersten Bereich ein Wert unterhalb der Abwärtsschwelle vorliegt, wird ein Pufferblock im zweiten Bereich gesucht. Ebenso wird bei einer Erhöhung des Wear-Level-Class-Zählers im zweiten Bereich ein Wert oberhalb der Aufwärtsschwelle erreicht, wird ein Pufferblock im ersten Bereich gesucht. Auf diese Weise wird eine an die Charakteristik der verwendeten Typen von Flashchips orientierte Löschhäufigkeit der Blöcke innerhalb des gesamten Speichers erreicht. Die Lebensdauer aller Flashchips des gesamten Speichers wird maximal ausgenutzt.

In dem beschriebenen Verfahren wird auch die verbliebene Zuverlässigkeit der Flashchips überprüft. Dazu wird beim Schreiben von Daten über die Daten ein Fehlerkorrekturwort gebildet und mit in dem Block abgespeichert wird, sowie über den Inhalt des Blockes ein Paritätswort gebildet und abgespeichert. Wenn nun einer oder mehrere Fehler beim Lesen der Daten erkannt werden, werden diese mittels des Fehlerkorrekturwortes korrigiert und mittels des Paritätswortes noch einmal überprüft. Wenn nun die Fehleranzahl in der Nähe der Fehlerkorrekturmöglichkeiten des Speichersystems (z.B. vier oder mehr Bitfehler bei einer Korrekturfähigkeit des Speichers von 6 Bitfehlern) liegt, ist dies ein Zeichen für die nachlassende Zuverlässigkeit des Speichers und es wird eine ,außerordentliche' Wearlevelprozedur auf dem Block durchgeführt bzw. der Block wird für eine solche Wearlevelprozedur vorgemerkt, falls der Block gerade zum Schreiben geöffnet ist. Die Vormerkung wird abgehandelt, sobald der Block geschlossen wird. Dabei werden dann die Daten, die aktuell mit korrigierbaren Mehrbitfehlern abgespeichert sind, in einen anderen, noch am seltensten gelöschten Block umkopiert und somit einem Refresh unterzogen. Damit werden insbesondere solche Lesefehler vermieden, die umgebungs- und datenabhängig sind.

Weiterhin sind für den ersten und den zweiten Bereich des Blockes maximal zulässige Löschungen des Speichers vorgegeben. Erreicht nun bei einer Erhöhung eines Wear-Level-Class-Zählers deren aktueller Wert den vorgegebenen Maximal-Wert wird eine Warnmeldung ausgegeben. Diese kann von dem Computersystem mit bekannten Verfahren ausgewertet werden.

Ausführungsformen der Erfindung sind in den Figuren beispielhaft beschrieben.
Fig. 1 zeigt ein Blockdiagramm eines Flashspeichersystems.
Fig. 2 zeigt die Adresszuordnung zu den Bereichen im Flashspeicher.
Fig. 3 zeigt den Aufbau eines physikalischen Blockes.
Fig. 4 zeigt das Wear-Levelling im Speicher.
Fig. 5 zeigt das Wear-Levelling mit Verschiebung eines Blockes in den MLC-Bereich.
Fig. 6 zeigt das Wear-Levelling mit Verschiebung eines Blockes in den SLC-Bereich.
Fig. 7 zeigt die Ausgabe einer Warnmeldung beim nahen Erreichen der maximalen Lebensdauer.

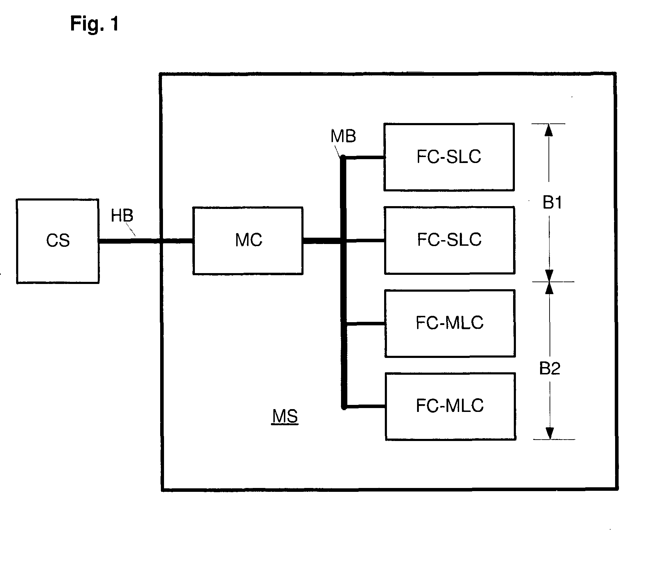

In Fig. 1 ist das Speichersystem MS mit dem Speichercontroller MC gezeigt, der über einen Hostbus HB mit dem steuernden Computersystem CS verbunden ist. An dem Speichercontroller MC sind über den Speicherbus MB die Flashchips FC, die den Datenspeicher bilden. Es sind zwei Typen von Flashchips FC vorhanden, wobei die SLC-Chips FC-SLC dem ersten Bereich B1 und die MLC-Chips FC-MLC dem zweiten Bereich zugeordnet sind. Die SLC-Chips FC-SLC weisen gegenüber den MLC-Chips FC-MLC eine wesentlich höhere maximale Löschmöglichkeit auf.

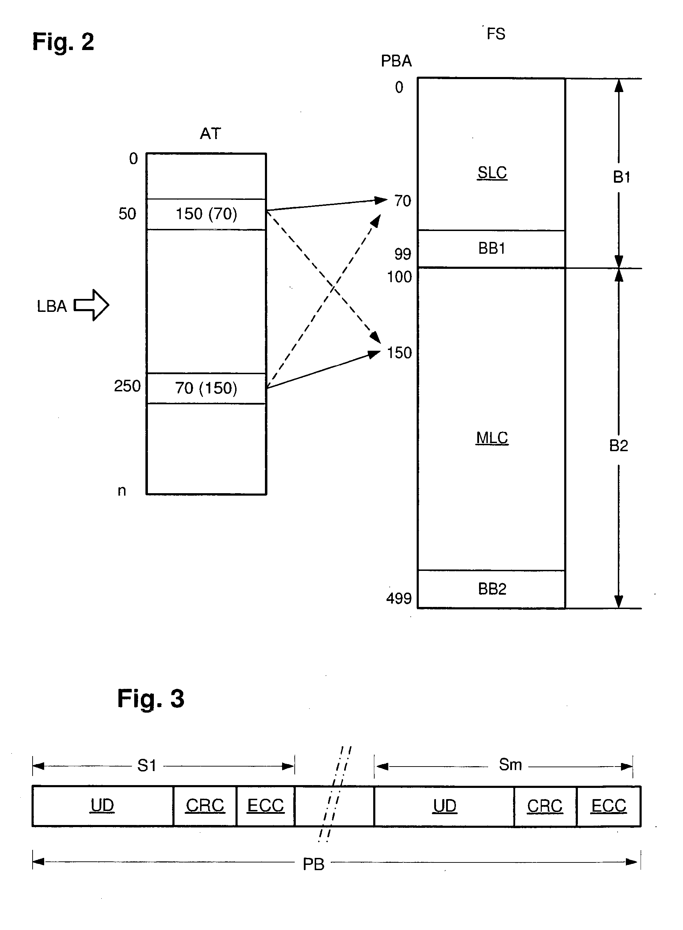

In Fig. 2 ist die Adresstabelle AT und der Flashspeicher FS mit den beiden Bereichen B1 und B2 dargestellt. Die vom Computersystem vorgegebene logische Blockadresse LBA wird in eine zugehörige physikalische Blockadresse PBA umgesetzt. Dabei dient die logische Blockadresse LBA als Index in die Adresstabelle AT.

In dem hier gezeigten Beispiel besteht der Flashspeicher FS aus 500 Blöcken mit den physikalischen Blockadressen PBA von 0 bis 499. Dabei enthält der erste Bereich B1 100 Blöcke vom Typ SLC und der zweite Bereich B2 400 Blöcke vom Typ MLC. In jedem Bereich sind für die Schreiboperationen Pufferblöcke BB1, BB2 vorgesehen.

In dem hier gezeigten Beispiel weist die logische Blockadresse 50 zunächst auf den Block 150 im MLC-Bereich, während der logischen Blockadresse 250 der Block 70 im SLC-Bereich zugeordnet ist. Bei einem Schreibvorgang auf die logische Blockadresse 50 wird nun ein Block im SLC-Bereich gesucht, der einen niedrigen Wert des Löschzählers besitzt. Dies sei der Block 70, der der logischen Blockadresse 250 zugeordnet ist. Damit nun der Schreibvorgang in den SLC-Bereich hinein erfolgt, werden die physikalischen Blockadressen der in der Adresstabelle AT getauscht. Nun zeigt die logische Blockadresse 50 auf den Block 70 im SLC-Bereich und die logische Blockadresse 250 auf den Block 150.

Fig. 3 zeigt den Aufbau eines physikalischen Blockes PB. Er ist in die Sektoren S1 bis Sm gegliedert, die jeweils den Nutzdatenbereich UD, ein Paritätswort CRC und das Fehlerkorrekturwort ECC enthalten. Daneben gibt es für jeden physikalischen Block PB einen Eintrag in der Blockmanagementtabelle, der den Löschzähler EC und die Angabe der Wear-Level-Class WLC enthält. Die Wear-Level-Class WLC kann auch aus dem oberen Teil des Löschzählers EC gebildet sein.

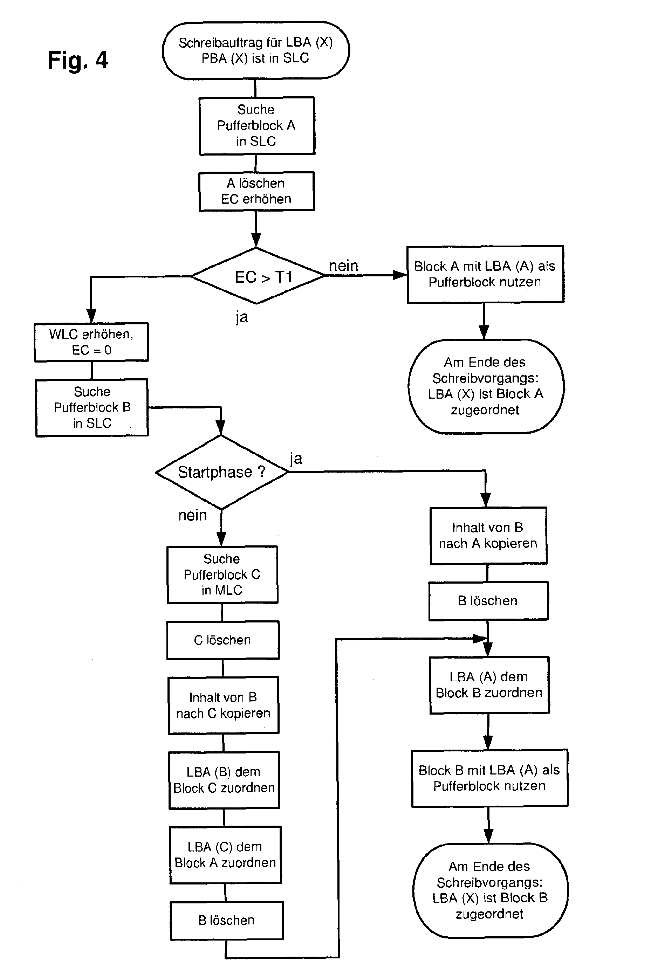

In Fig. 4 ist das Wear-Leveling-Verfahren des Speichers dargestellt. Bei einem Schreibauftrag für den logischen Block X weist die logische Blockadresse LBA (X) auf die physikalische PBA (X) im SLC-Bereich. Dort wird ein Pufferblock A gesucht und dieser gelöscht. Dabei wird der Löschzähler EC erhöht. Wenn der Löschzähler von A die Schwelle T1 für die Erhöhung der WearLevel-Class nicht überschreitet, wird Block A als Pufferblock genutzt und die logische Blockadresse (X) dem Block A zugeordnet. Wenn der Löschzähler von A nun die Schwelle T1 für die Erhöhung der WearLevel-Class überschreitet, wird diese erhöht und der Löschzähler zurückgesetzt. Es wird ein weiterer Block B im SLC- Bereich gesucht, und zwar derjenige mit dem kleinsten Löschzähler.

In der Startphase wird nun der Inhalt von B in den gerade gelöschten Block A kopiert und B gelöscht. Ohne Beschränkung der Allgemeinheit darf hier vorausgesetzt werden, dass dieses Löschen hier nicht zur Erhöhung der Wear-Level-Class führt.

Die logische Blockadresse LBA (A) wird dem Block B zugeordnet und dieser als Pufferblock genutzt. Am Ende des Schreibvorganges ist die logische Blockadresse LBA (X) dem Block B zugeordnet.

In der Startphase werden alle SLC-Flashchips beschrieben. Nach der Startphase wird bei der Erhöhung der Wear-Level-Class ein freier Pufferblock C in den MLC-Flashchips mit einem niedrigen Wert der Wear-level-Class gesucht. Dieser Block C wird gelöscht, der Inhalt des Blockes B hineinkopiert und die logische Blockadresse LBA (B) dem Block C zugeordnet. Die logische Blockadresse LBA (C) wird dem gelöschten Block A zugeordnet. Der Block B wird nun auch gelöscht.

Die logische Blockadresse LBA (A) wird dem Block B zugeordnet und dieser als Pufferblock genutzt. Am Ende des Schreibvorganges ist nun auch die logische Blockadresse LBA (X) dem Block B zugeordnet.

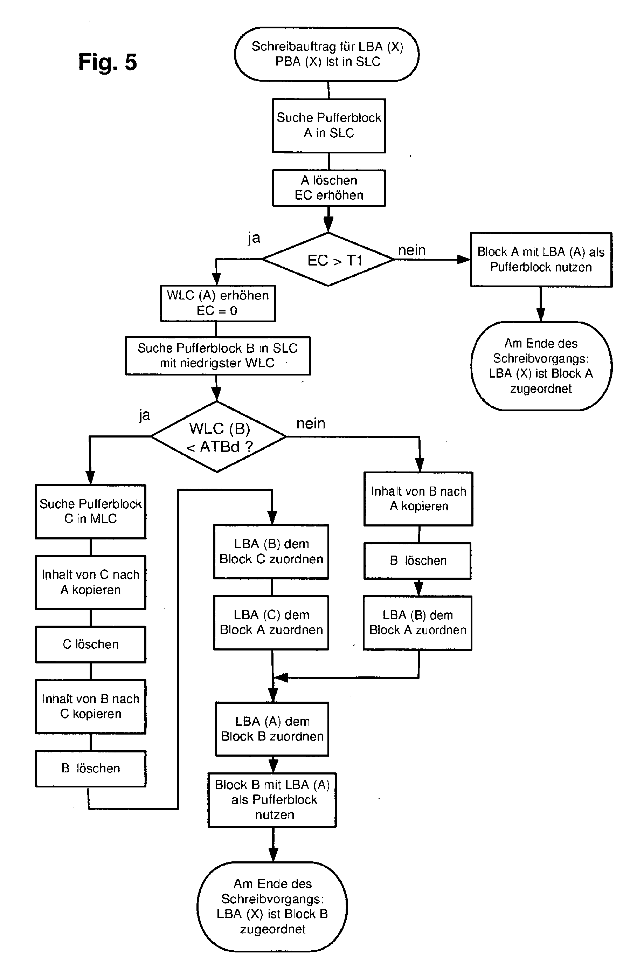

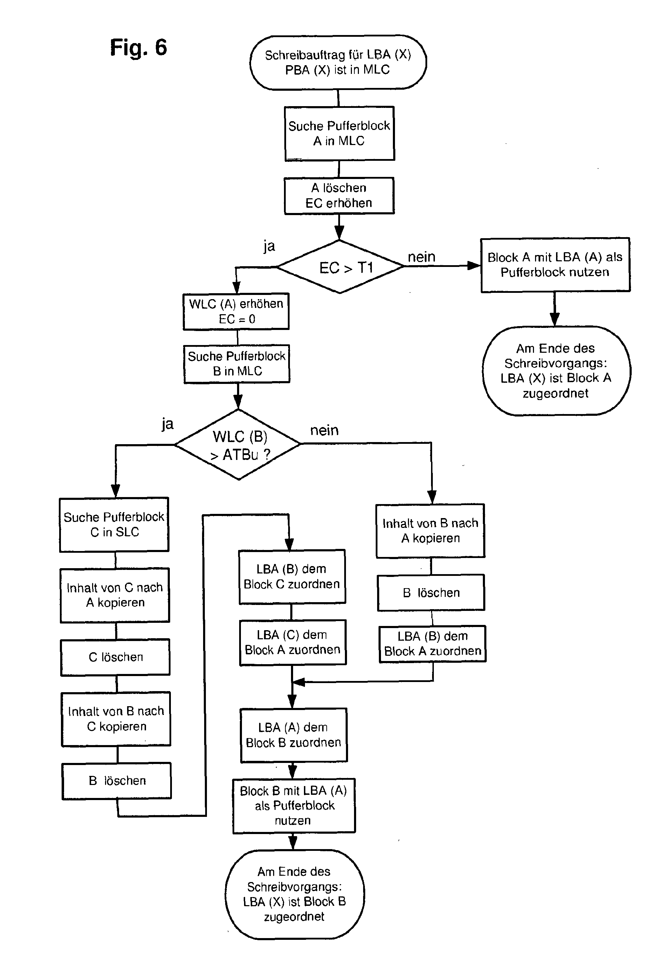

In Fig. 5 und 6 sind die Wear-Level-Verfahren mit einer Verschiebung des zu schreibenden Blockes in den jeweils anderen Bereich dargestellt. Der Beginn des Schreibvorgangs entspricht dem Verfahren gemäß Fig. 4.

In Fig. 5 liegt ein Schreibauftrag für die logische Blockadresse LBA (X) im SLC-Bereich vor. Dort wird ein Bufferblock A gesucht, dieser gelöscht und sein Löschzähler EC erhöht. Wenn der Löschzähler von A die Schwelle T1 für die Erhöhung der WearLevel-Class nicht überschreitet, wird Block A als Pufferblock genutzt und die logische Blockadresse (X) dem Block A zugeordnet.

Wenn der Löschzähler von A nun die Schwelle T1 für die Erhöhung der WearLevel-Class überschreitet, wird diese erhöht und der Löschzähler zurückgesetzt. Es wird ein weiterer Block B im SLC- Bereich gesucht.

Nun wird überprüft, ob die Wear-Level-Class des Blockes B kleiner ist als eine vorgegebene Schwelle ATBd, die eine Verschiebung von Blöcken aus dem SLC-Bereich in den MLC-Bereich bewirkt.

Wenn diese Schwelle nicht unterschritten ist, wird der Inhalt des Blocks B in den gelöschten Block A kopiert, und Block B gelöscht. Die logische Blockadresse LBA (A) wird dem Block B zugeordnet und dieser als Pufferblock genutzt. Am Ende des Schreibvorganges ist die logische Blockadresse LBA (X) dem Block B zugeordnet.

Wenn die Schwelle ATBd unterschritten ist, wird ein freier Pufferblock C in den MLC-Flashchips mit einem niedrigen Wert der Wear-level-Class gesucht. Der Inhalt des Blockes C wird nach A kopiert und dann Block C gelöscht. Der Inhalt des Blockes B wird nach C kopiert und Block B gelöscht. Die logische Blockadresse LBA (B) wird dem Block C und die logische Blockadresse LBA (C) dem gelöschten Block A zugeordnet.

Die logische Blockadresse LBA (A) wird dem Block B zugeordnet und dieser als Pufferblock genutzt. Am Ende des Schreibvorganges ist nun auch die logische Blockadresse LBA (X) dem Block B zugeordnet.

In Fig. 6 ist das gleiche Wear-Leveling-Verfahren wie in Fig. 5 mit einer Verschiebung eines Blockes C aus dem MLC-Bereich in den SLC-Bereich dargestellt. Es liegt ein Schreibauftrag für einen Block im MLC-Bereich vor. Wenn der Pufferblock B aus dem MLC-Bereich eine Wear-Level-Class größer als die Schwelle ATBu für die Verschiebung aus dem MLC-Bereich in den SLC-Bereich besitzt, wird sein Inhalt in den SLC-Bereich verschoben. Die Verfahrensschritte, nur angewendet auf den anderen Bereich, sind ansonsten die gleichen wie für Fig. 5 beschrieben.

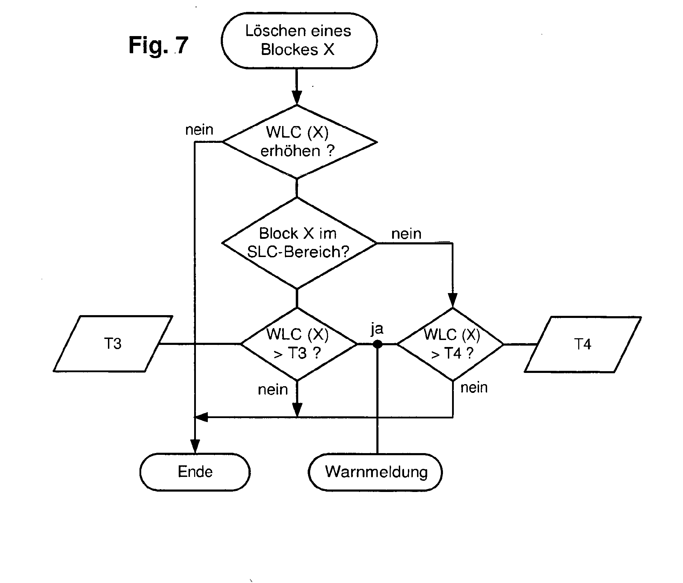

In Fig. 7 ist dargestellt, wie ein nahes Erreichen der maximalen Lebensdauer des Speichersystems erkannt und als Warnmeldung ausgegeben wird.

Wenn beim Löschen eines Blockes X die Wear-Level-Class WLC erhöht wird, wird überprüft, in welchem Bereich sich der Block befindet. Befindet er sich im SLC-Berich wird die Wear-Level-Class WLC mit einer SLC-Schwelle T3 verglichen. Ist der Wert höher als die Schwelle T3 wird eine Warnmeldung ausgegeben. Dies kann etwa etwa nach dem bei Festplatten bekannten SMART-Verfahren erfolgen.

Befindet sich der Block X im MLC-Berich wird die Wear-Level-Class WLC mit einer MLC-Schwelle T4 verglichen. Ist der Wert höher als die Schwelle T4 wird ebenso eine Warnmeldung ausgegeben.

Somit kann auf einfache Weise das nahe Erreichen der maximalen Lebensdauer des Speichersystems vom Anwender bemerkt werden.

### Bezugszeichen:

- A, B, C, X: Physikalische Blöcke
- AT: Adresstabelle
- ATBu,: Schwelle für Bereichswechsel in den SLC-Bereich
- ATBd: Schwelle für Bereichswechsel in den MLC-Bereich
- B1: erster Bereich
- B2: zweiter Bereich
- BB1: Pufferblöcke im ersten Bereich
- BB2: Pufferblöcke im zweiten Bereich
- BEF: Löschhäufigkeit des Blockes
- CRC: Paritätswort
- CS: Computersystem
- EC: Löschzähler
- ECC: Fehlerkorrekturwort
- FC: Flashchip
- FS: Flashspeicher
- HB: Hostbus
- LBA: Logische Blockadresse
- MB: Speicherbus
- MC: Speichercontroller
- MLC: Multi-Level-Cell-Speicher
- MS: Speichersystem
- m: Anzahl Sektoren
- n: Anzahl logische Blockadressen
- PB: Physikalischer Block
- PBA: Physikalische Blockadresse
- SLC: Single-Level-Cell-Speicher
- Sl, Sm: Sektoren im Block
- T1...T4: Schwellen für Löschzähler
- UD: Nutzdaten
- WLC: Wear-Level-Class

## Patentansprüche

1. Verfahren zur Verwaltung eines Flashspeichers mit mehreren Flashchips, die in eine Vielzahl von separat löschbaren physikalischen Blöcken gegliedert sind und diese Blöcke eine begrenzte maximale Löschhäufigkeit besitzen, und die Blöcke des Speichers über logische Blockadressen (LBA) adressiert werden, die über eine Adresstabelle (AT) in physikalische Blockadressen umgesetzt werden, und in jedem Block ein Löschzähler mitgeführt wird, in dem die Anzahl der Löschungen des Blockes gezählt wird, wobei
in dem Flashspeicher (FS) zwei Bereiche mit unterschiedlichen Typen von Flashchips vorhanden sind, wobei der erste Bereich (B1) Single-Level-Flashchips mit einer sehr großen maximalen Löschhäufigkeit enthält und der zweite Bereich (B2) Multi-Level-Flashchips mit einer niedrigeren maximalen Löschhäufigkeit enthält, und dass
- beim Beschreiben des Speichers die Adressumsetzung der logischen Adressen in physikalische Adressen zunächst so erfolgt, dass alle Blöcke des ersten Bereiches (B1) beschrieben werden,
- wenn alle Blöcke des ersten Bereiches beschrieben sind und ein weiterer Schreibvorgang auszuführen ist, der Block in dem ersten Bereich (B1) mit dem niedrigsten Löschzähler in einen unbeschriebenen Block im zweiten Bereich kopiert wird,
- in der Adresstabelle (AT) die physikalischen Blockadressen zu den zugeordneten logischen Blockadressen (LBA) dieser Blöcke getauscht werden,
- der Block im ersten Bereich gelöscht wird, und
- dieser Block mit den neuen Daten beschrieben wird, **dadurch gekennzeichnet, dass**
für jeden Bereich eine Wear-Level-Schwelle (T1, T2) definiert wird und zu jedem Block ein Wear-Level-Class-Zähler (WLC) geführt wird, der bei einem Erreichen der für diesen Block gültigen Wear-Level-Schwelle des Löschzählers (EC) erhöht wird und der Löschzähler auf 0 gesetzt wird.

2. Verfahren nach Anspruch 1, **dadurch gekennzeichnet, dass**
in beiden Bereichen gelöschte Pufferblöcke (BB1, BB2) vorgehalten werden, in die neue Daten für bereits beschriebene Blöcke eingeschrieben werden.

3. Verfahren nach Anspruch 2, **dadurch gekennzeichnet, dass**
nach dem Schreiben von neuen Daten eines Blockes in einen Pufferblock die physikalische Adresse dieses Blockes zu der logischen Blockadresse in die Adresstabelle (AT) eingetragen wird, der bisherige Block gelöscht wird und sein Löschzähler (EC) erhöht wird.

4. Verfahren nach Anspruch 1, **dadurch gekennzeichnet, dass**
bei einer Suche nach einem Pufferblock nach einem gelöschten Block mit einem niedrigen Wert des Wear-Level-Class-Zählers in dem gleichen Bereich des Speichers gesucht wird.

5. Verfahren nach Anspruch 1, **dadurch gekennzeichnet, dass**
für den Übergang vom ersten Bereich in den zweiten Bereich eine Abwärtsschwelle (ATBu) und für den Übergang vom zweiten Bereich zum ersten Bereich eine Aufwärtsschwelle (ATBd) definiert ist.

6. Verfahren nach Anspruch 5, **dadurch gekennzeichnet, dass**
für den ersten Bereich die Abwärtsschwelle (ATBd) der höchste aktuelle Wert der Wear-Level-Class-Zähler (WLC) im zweiten Bereich ermittelt wird, und dass für den zweiten Bereich die Aufwärtsschwelle (ATBu) der niedrigste aktuelle Wert der Wear-Level-Class-Zähler im ersten Bereich ermittelt wird.

7. Verfahren nach Anspruch 5, **dadurch gekennzeichnet, dass**
bei einer Erhöhung des Wear-Level-Class-Zählers (WLC) im ersten Bereich ein Unterschreiten der Abwärtsschwelle (ATBd) überprüft wird und falls diese unterschritten ist, ein Pufferblock im zweiten Bereich genutzt wird.

8. Verfahren nach Anspruch 5, **dadurch gekennzeichnet, dass**
bei einer Erhöhung des Wear-Level-Class-Zählers (WLC) im zweiten Bereich ein Überschreiten der Aufwärtsschwelle (ATBu) überprüft wird und falls diese überschritten wird, ein Pufferblock im ersten Bereich genutzt wird.

9. Verfahren nach Anspruch 1, **dadurch gekennzeichnet, dass**
beim Schreiben von Daten über die Daten ein Fehlerkorrekturwort (ECC) gebildet und mit in dem Block abgespeichert wird, sowie über den Inhalt des Blockes eine Paritätswort (CRC) gebildet und abgespeichert wird.

10. Verfahren nach Anspruch 9, **dadurch gekennzeichnet, dass**
bei einem Auftreten mehrerer Fehler beim Lesen aus einem Block unmittelbar eine Wearlevelprozedur für diesen Block durchgeführt wird.

11. Verfahren nach Anspruch 1, **dadurch gekennzeichnet, dass**
für den ersten und den zweiten Bereich die jeweils maximal zulässigen Löschungen von Blöcken vorgegeben sind und bei einer Erhöhung der Wear-Level-Class-Zähler deren aktueller Wert mit den vorgegebenen Werten (T3, T4) verglichen wird und bei einem Erreichen der maximal zulässigen Löschungen eine Warnmeldung ausgegeben wird.

## Claims

1. A method for managing a flash memory having a plurality of flash chips organized in a plurality of physical blocks that can be erased separately, the blocks having a limited maximum erase frequency, and the blocks of the memory being addressed by way of logic block addresses (LBA) are converted into physical block addresses by way of an address table (AT), and in each block an erase counter is run in which a number of erasures of the block is counted, wherein the flash memory (FS) has two regions with different types of flash chips, wherein the first region (B1) contains single-level flash chips having a very large maximum erase frequency, and a second region (B2) contains multi-level flash chips having a lower maximum erase frequency, and
- when writing to the memory, the address conversion of logic addresses into physical addresses is initially carried out in such a way that all the blocks of the first region (B1) are written;
- when all the blocks of the first region have been written and a further write process is to be carried out, the block in the first region (B1) having the lowest erase counter is copied into a blank block in the second region;
- in the address table (AT), the physical block addresses assigned to the logic block addresses of these blocks are switched,
- the block in the first region is erased, and
- this block is written with new data,
**characterized in that**
a wear-level threshold (T1, T2)is defined for each region and for each block a wear-level class counter (WLC) is run, which is incremented when anerase counter (EC) attains a wear-level threshold valid for the block, and the erase counter is set to 0.

2. The method according to claim 1, **characterized in that** in both regions erased buffer blocks (BB1, BB2) are designated, into which further new data is written for the blocks that have already been written.

3. The method according to claim 2, **characterized in that**,after writing new data of the block to a buffer block, the physical address of the block is assigned to the logic block address in the address table (AT), the previous block is erased and its erase counter (EC) is incremented.

4. The method according to claim 1, **characterized in that**,during a search for a buffer block, a deleted block with a low value of the wear-level class counter is searched in the same region of the flash memory.

5. The method according to claim 1, **characterized in that** a downward threshold (ATBd) is defined for the transition from the first region to the second region, and an upward threshold (ATBu) is defined for the transition from the second region to the first region.

6. The method according to claim 5, **characterized in that** the downward threshold (ATBd) for the first region is determined as the highest current value of the wear-level class counters (WLC) in the second region, and that the upward threshold (ATBu) for the second region is determined as the lowest current value of the wear-level class counters in the first region.

7. The method according to claim 5, **characterized in that**,when the wear-level class counter (WLC) in the first region is incremented, it is checked whether it comes below the downward threshold (ATBd) and if this is the case, a buffer block in the second region is used.

8. The method according to claim 5, **characterized in that**,when the wear-level class counter (WLC) in the second region is incremented, it is checked whether it exceeds the upward threshold (ATBu) and if this is the case, a buffer block in the first region is used.

9. The method according to claim 1, characterized in thatwhen writing the data, an error correction word (ECC) is formed across the data and the error correction word is stored in the same block, and a parity word (CRC)is formed across the content of the physical block and the parity word is stored.

10. The method according to claim 9, characterized in thatupon an occurrence of multiple errors while reading from a block, a wear-level process is performed immediately for this block.

11. The method according to claim 1, **characterized in that** for the first and the second regions respectively, a maximum of permitted erasures of the blocks is set and, when wear-level class counters are incremented, their current value is compared with the set values (T3, T4)and, if a maximum of permitted erasures is attained, a warning is issued.

## Revendications

1. Procédé de gestion d' une mémoire flash ayant une pluralité de puces flash, lesdits puces étant organisés en une pluralité de blocs physiques qui peuvent être effacés séparément et qui ont une fréquence d'effacement maximale limitée, les blocs de la mémoire étant adressée par des adresses de bloc logique (LBA) qui sont converties en adresses de bloc physiques par l'intermédiaire d' une table d'adresses (AT), et dans chaque bloc un compteur d'effacement est effectué, dans lequel un nombre d'effacements de bloc est compté, dans lequel la mémoire flash (FS) présente deux régions avec des différents types de puces flash, dans lequel la première région (B1) contient des puces SLC ayant une fréquence d'effacement maximaletrès élevée, et une deuxième région (B2) contient des puces MLC ayant une fréquence d'effacement maximale inférieure, et
- lors de l'écriture de la mémoire, la conversion des adresses logiques en adresses physiques est initialement effectuée de manière que tous les blocs de la première région (B1) sont écrites,
- lorsque tous les blocs de la première région ont été écrits et un nouveau processus d'écriture doit être effectuée, le bloc dans la première région (B1) ayant le compteur d'effacement le plus bas est copié dans un bloc vide dans la deuxième région,
- dans la table d'adresses (AT), lesadresses de bloc physiques attribuées aux adresses de bloc logiques(LBA) de ces blocs sont échangés,
- le bloc dans la première région est effacé, et
- ce bloc est écrit avec de nouvelles données,
**caractérisé en ce que**
un seuil de niveau d'usure (T1, T2) est définie pour chaque région, et pour chaque bloc un compteur de classe de niveau d'usure (WLC) est effectué, qui est incrémenté quand un compteur d'effacements (EC) atteint un seuil de niveau d'usure valable pour ce bloc, et le compteur d'effacements est réglé sur 0.

2. Procédé selon la revendication 1 , **caractérisé en ce que**, dans les deux régions,des blocs tampons effacées (BB 1 ,BB2) sont désignées, dans lesquels de nouvelles données sont écrites pour les blocs physiques qui ont déjà été écrits.

3. Procédé selon la revendication 2, **caractérisé en ce que**, après l'écriture de nouvelles données d'un bloc dans un bloc tampon , l'adresse physique du bloc est entrée à l'adresse de bloc logique dans la table d'adresses (AT), le bloc précédent est effacé et son compteur d'effacement (EC) est incrémenté.

4. Procédé selon la revendication 1, **caractérisé en ce que**, lors d'une recherche d'un bloc tampon, un bloc effacé avec une valeur basse du compteur de classe de niveau d'usure est recherché dans la même région de la mémoire flash.

5. Procédé selon la revendication 1, **caractérisé en ce que** un seuil de descente (ATBd) est défini pour le passage de la première région à la deuxième région, et un seuil d'augmentation (ATBu) est défini pour le passage de la deuxième région à la première région.

6. Procédé selon la revendication 5, **caractérisé en ce que** le seuil de descente (ATBd) pour la première région est déterminé en tant que la valeur la plus élevée des compteurs de classe de niveau d'usure (WLC) dans la deuxième région, et que le seuil d'augmentation (ATBu) pour la deuxième région est déterminée en tant que la valeur la plus basse des compteurs de classe de niveau d'usure de la première région.

7. Procédé selon la revendication 5, **caractérisé en ce que**, lorsque le compteur de classe de niveau d'usure (WLC) dans la première région est incrémenté, il est vérifié si sa valeur descend en dessous du seuil de descente (ATBd) et, si tel est le cas , un bloc tampon dans la deuxièmerégion est utilisé.

8. Procédé selon la revendication 5, **caractérisé en ce que**, lorsque le compteur de classe de niveau d'usure (WLC) dans la deuxième région est augmenté , il est vérifié si sa valeur dépasse le seuil d'augmentation (ATBu) et, si tel est le cas , un bloc tampon dans la première région est utilisé.

9. Procédé selon la revendication 1, **caractérisé en ce que**, lors de l'écriture des données, un mot de correction d'erreurs (ECC) est forméà travers les données et le mot de correction d'erreurs est stocké dans le même bloc, et un mot de parité (CRC) est formé à travers le contenu du bloc et le mot de parité est stocké.

10. Procédé selon la revendication 9, **caractérisé en ce que**, lors de l'apparition d'erreurs multiples lors de la lecture d'un bloc, un procédé de niveau d'usure est effectuée immédiatement pour ce bloc.

11. Procédé selon la revendication 1, **caractérisé en ce qu'**un maximum d'effacements des blocs autorisésest défini pourla première et la deuxième région, respectivement, et, lorsque les compteurs de classe de niveau d'usure sont incrémentés, leur valeur actuelle est comparée avec les valeurs définies (T3, T4) et, si un maximum d'effacements autorisés est atteint, un avertissement est émis.
